# EUROPEAN PATENT SPECIFICATION

(11) **EP 2 182 099 B1**
(45) Date of publication and mention of the grant of the patent: **17.08.2016**
(21) Application number: 09000723.8
(22) Date of filing: 20.01.2009
(51) Int. Cl.: C30B 15/10, C30B 29/06, C30B 35/00, C03B 19/09

(54) **Silica glass crucible having multilayered structure**
Quarzglastiegel mit Mehrschichtstruktur
Creuset en verre de silice doté d'une structure multicouche

(30) Priority: 31.10.2008 JP 2008281169
(43) Date of publication of application: 05.05.2010
(73) Proprietor: Japan Super Quartz Corporation, Akita-shi Akita-ken 010-0065 (JP)
(72) Inventor: Kodama, Makiko, Akita-ken 010-0065 (JP); Morikawa, Masaki, Akita-ken 010-0065 (JP)
(74) Representative: Glienke, Jens

(56) References cited:
- WO-A-01/92609
- JP-A- 2005 219 997
- US-A- 5 306 473
- US-A- 5 885 071

## Description

The present invention relates to a silica glass crucible having a multilayered structure that is employed in the pulling of silicon single crystals for use as semiconductor materials.

### DISCUSSION OF THE BACKGROUND

In the silica glass crucibles employed in the pulling of silicon single crystals, the quality of the inner surface coming in contact with the silicon melt greatly affects the pulling yield and the quality of the crystals that are pulled. In particular, when bubbles are present in the vicinity of the inner surface of the crucible walls (peripheral wall and bottom wall) that come into contact with the silicon melt, the single crystallization yield (single crystallization rate) is known to decrease. Thus, it is necessary for the inner surface of a silica glass crucible to be a transparent, pure glass layer containing as few bubbles and impurities as possible. This inner surface is often formed out of synthetic quartz containing few impurities.

The rotating mold method is currently the mainstream method of manufacturing silica glass crucibles. In this method, quartz powder serving as the starting material is deposited by centrifugal force on the inner surface of a crucible-shaped mold that is being rotated, and the quartz powder that has been deposited on the rotating mold is fused and vitrified by arc discharge heating to mold it into the shape of a crucible. In this case, the following two methods are known for forming high-purity transparent quartz layers with few bubbles on the inner surface of a crucible. In the first method, the quartz layer is aspirated under reduced pressure from the mold side during arc fusion of the quartz powder; in the course of vitrification by fusing the quartz powder, the quartz layer is subjected to reduced pressure to aspirate bubbles from the interior out to the exterior to form a transparent glass layer containing few bubbles (Japanese Unexamined Patent Publication (KOKAI) Heisei Nos. 01-157426, 01-160836, and the like). In the second method, quartz powder is fused by being passed through an arc, and the fused quartz powder is laminated on the inner surface of a premolded silica glass crucible to form a transparent glass layer (Japanese Unexamined Patent Publication (KOKAI) Heisei No. 01-148718, US Patent Nos. 4935046 and 4956208, the English family thereof, and the like). Either of these methods permits the manufacturing of a silica glass crucible with a synthetic quartz layer of high purity on the inner surface thereof when synthetic quartz powder of high purity is employed.

In a silica glass crucible that is manufactured by the above rotating mold method, a high-purity, transparent quartz layer with few bubbles is formed on the inner surface of the crucible, and an opaque layer of higher bubble content than the transparent quartz layer is present on the outer surface side.

The size of the silicon single crystals that are manufactured by pulling with silica glass crucibles has been increasing in approximately ten-year cycles. It is desirable for device manufacturers to increase the size of the silicon single crystals and increase the size of the wafers that are cut from the silicon single crystals to enhance the efficiency of device manufacturing. For this reason, the manufacturing of silicon single crystals having diameters of about 1.5-fold the current diameter of 300 mm is anticipated in the near future.

As the size of the silicon single crystal increases, the size of the silica glass crucible will necessarily increase. To manufacture large silicon single crystals of high quality, it does not suffice to simply increase the size of the silica glass crucible. For example, achieving a homogenous large silicon single crystal requires rendering uniform the surface state of the inner surface of the silica glass crucible and uniformly heating the silica glass crucible.

In conventional silica glass crucibles having a transparent quartz layer on the inner surface thereof and having an opaque layer on the outside, there is variation in the thickness of the transparent quartz layer and the opaque layer. This variation in thickness prevents uniform heating of the silica glass crucible, resulting in localized variation in the temperature of the silicon melt. Even in the manufacturing (pulling) of the current silicon single crystals 300 mm in diameter, such variation affects the quality of the silicon single crystal. Accordingly, various silica glass crucibles have been proposed to maintain the quality of silicon single crystals. In these silica glass crucibles, used for pulling silicon single crystals, the portion of the wall on the inner surface side is comprised of a transparent glass layer that is substantially free of bubbles, and the portion of the wall on the outer surface side is comprised of an opaque glass layer containing numerous bubbles. Their structures and the like have various characteristics (Japanese Unexamined Patent Publication (KOKAI) Heisei Nos. 06-101986, 06-329493, 08-169798, and 09-157082).

However, in the manufacturing (pulling) of ever larger silicon single crystals as set forth above, the negative effects on the quality of the silicon single crystals increase. Even in the silica glass crucibles described in Japanese Unexamined Patent Publication (KOKAI) Heisei Nos. 06-191986, 06-329493, 08-169798 and 09-157082, there is a problem in that it is difficult to maintain the quality of the silicon single crystals.

Accordingly, the present invention, devised to solve the above-described problem, has for its object to provide a silica glass crucible permitting the manufacturing (pulling) of homogenous silicon single crystals by inhibiting localized variation in the temperature of the silicon melt, even when manufacturing (pulling) large silicon single crystals.

US 5,306,473 discloses a quartz glass crucible for pulling a single crystal, which comprises a cylindrical straight portion, a bottom portion and a curved intermediate portion for connecting the same. A part of the straight portion, the curved intermediate portion and the bottom portion consist of two layers. One layer is a transparent layer having a total volume of bubbles about 0.4 % and the other layer is an opaque layer having a total volume of bubbles in the range from 0.7 to 3 %. An intermediate layer may exist between inner transparent layer and the outer opaque layer, in which the bubble volume is greater than that of the transparent layer and smaller than of the opaque layer.

### SUMMARY OF THE INVENTION

The present invention relates to a silica glass crucible employed in the pulling of silicon single crystals as defined in claim 1.

The present invention provides a silica glass crucible permitting the manufacturing (pulling) of homogenous silicon single crystals by inhibiting localized variation in the temperature of the silicon melt, even when manufacturing (pulling) large silicon single crystals. The present invention further provides a method for manufacturing the silica glass crucible of the present invention affording such advantages.

Other exemplary embodiments and advantages of the present invention may be ascertained by reviewing the present disclosure and the accompanying drawings.

### BRIEF DESCRIPTION OF THE DRAWINGS

The present invention will be described in the following text by the exemplary, nonlimiting embodiments shown in the figures, wherein:
Fig. 1 shows a conceptual sectional view of a conventional silica glass crucible and a conceptual sectional view of the silica glass crucible of the present invention.

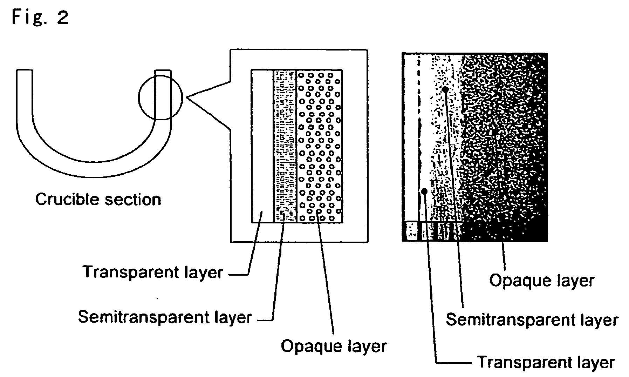

Fig. 2 shows a sectional photograph of a silica glass crucible manufactured in an embodiment (right). The figure in the middle is an enlarged conceptual sectional view of the silica glass crucible.
Fig. 3 shows the relation between the thickness ratio (semitransparent layer: opaque layer) and the single crystal yield for quartz crucibles 45.7 cm (18 inches) in size (Embodiments 3 to 5 and Comparative Example 1).
Fig. 4 shows the relation between the presence or absence of a semitransparent layer and the single crystal yield for quartz crucibles 45.7cm (18 inches), 61 cm (24 inches), and 81.3 cm (32 inches) in size (Embodiment 4 and Comparative Example 1; Embodiment 7 and Comparative Example 2; and Embodiment 10 and Comparative Example 3).

### DESCRIPTIONS OF THE EMBODIMENTS

The silica glass crucible of the present invention, employed in pulling silicon single crystals, is characterized by comprising at least a transparent layer, semitransparent layer, and opaque layer disposed from the inner surface side to the outer surface side of the crucible in that the content of bubbles in the transparent layer is less than 0.3 percent; in that the content of bubbles in the semitransparent layer falls within a range of from 0.3 to 0.7 percent; and in that the content of bubbles in the opaque layer is greater than 1.0 percent.

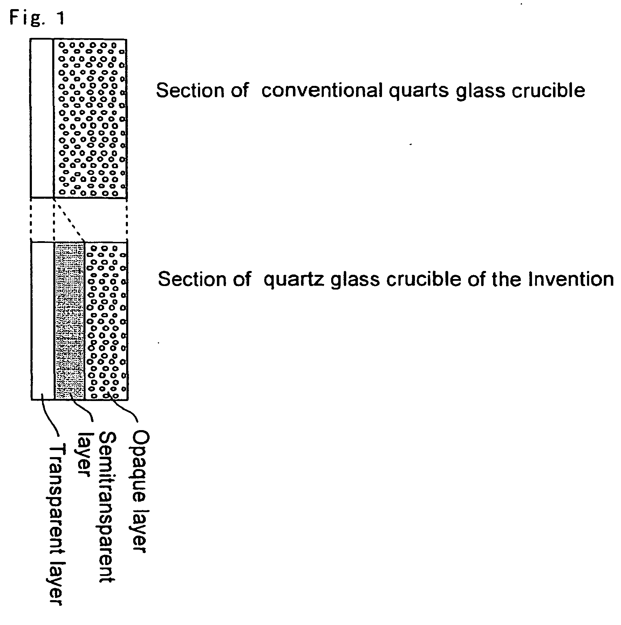

As shown in Fig. 1, a conventional silica glass crucible is comprised of just a transparent layer and an opaque layer (upper figure). However, the silica glass crucible of the present invention is comprised of at least a transparent layer, semitransparent layer, and opaque layer (lower figure).

Since the silica glass crucible of the present invention comprises the above transparent layer, semitransparent layer, and opaque layer, the heating characteristics of the silica glass crucible are enhanced, and localized variation in the temperature of the silicon melt within the crucible due to heating from outside the silica glass crucible is inhibited. As a result, for example, it is possible to manufacture homogenous silicon single crystals, even when manufacturing silicon single crystals having a diameter of about 1.5 times the current diameter of 300 mm.

The transparent layer has a bubble content of less than 0.3 percent, desirably a bubble content of 0.1 percent, and preferably a bubble content of 0.05 percent or less. When bubbles are internally contained in the vicinity of the inner surface of the crucible walls, the bubbles in the interior thermally expand during pulling, causing the inner surface of the crucible to partially separate, causing bubbles and small pieces of separated quartz to enter the silicon single crystal and induce polycrystallization, and diminishing the single crystallization yield (single crystallization rate). Accordingly, in the present invention, the content of bubbles in the transparent layer is desirably as low as possible.

In the semitransparent layer, the bubble content falls within a range of from 0.3 to 0.7 percent, desirably within a range of from 0.35 to 0.55 percent, and preferably within a range of from 0.4 to 0.5 percent.

In the opaque layer, the bubble content is greater than 1.0 percent or greater, and preferably 3.0 percent or less.

In the transparent layer, the thickness of the bottom portion of the crucible, for example, falls within a range of 0.5 to 10 mm. The thickness of the transparent layer in the bottom portion of the crucible desirably falls within a range of 2 to 5 mm.

The combined thickness of the semitransparent and opaque layers, for example, falls within a range of 5 to 50 mm. The combined thickness of the semitransparent and opaque layers desirably falls within a range of 10 to 50 mm. However, the combined thickness of the semitransparent and opaque layers can be suitably determined in consideration of the strength required of the crucible as a function of the size of the silica glass crucible, and the like.

The ratio of the thicknesses of the semitransparent and opaque layers (semitransparent layer: opaque layer) falls within a range of from 15:85 to 50:50, and preferably, within a range of from 20:80 to 40:60.

As set forth above, there are desirably as few bubbles as possible in the inside portion of the crucible so as to reduce the negative effect during the pulling of silicon single crystals. However, bubbles in the outer peripheral portion do not negatively affect pulling; naturally, an opaque layer that tends not to transmit infrared heat is suited to achieving an insulating effect during heating. The opaque layer is also advantageous in that it permits the achieving of a uniform temperature distribution due to greater propagation of heat by diffusion than the transparent layer. Thus, the outer peripheral side portion of the crucible is in the form of an opaque glass layer containing a large number of bubbles.

As the diameter of crucibles has increased, there has been a tendency to increase the thickness of the peripheral wall and bottom of the crucible to maintain strength. On the other hand, due to manufacturing limitations, it is difficult to exceed a certain transparent layer thickness. Thus, as the diameter of crucibles has increased, the thickness of the opaque layer has increased. However, as set forth above, the opaque layer tends not to transmit infrared radiation. Thus, it has a good insulating effect. However, this is a drawback from the perspective of effectively heating the interior of the crucible.

Accordingly, an opaque layer and a semitransparent layer that is provided between the opaque layer and the transparent layer are provided in the present invention, permitting effective heating by a heating means positioned outside the crucible. The insulating effect of this structure is also good. As a result, a high crystallization rate is achieved during the pulling of silicon single crystals.

From this viewpoint, and taking into account the combined thickness of the semitransparent layer and opaque layer, the thickness ratio of the semitransparent layer and the transparent layer is suitably selected so as to fall within the above range of from 15:85 to 50:50. The larger the proportion of the semitransparent layer becomes, the more efficiently the interior of the crucible can be heated, and the lower the insulating effect becomes. However, approximately the same insulating effect can sometimes be achieved when at least an opaque layer in a certain thickness is present; the relation between the proportion of the semitransparent layer and the insulating effect is also affected by the combined thickness of the semitransparent layer and the opaque layer.

### [Method of manufacturing a silica glass crucible]

The silica glass crucible of the present invention is manufactured by the rotating mold method. In this method, starting material quartz powder or quartz glass powder (sometimes referred to simply as "starting material powder" hereinafter) for forming the transparent layer, semitransparent layer, and opaque layer is deposited on the inner surface of a hollow mold for forming a silica glass crucible, after which a state of reduced pressure is generated from the inner surface toward the outer surface of the hollow mold through passages formed in the inner portion of the hollow mold, and the starting material quartz or quartz glass powder that has been deposited is fused by heating to prepare a silica glass crucible.

The starting material powder can be natural or synthetic (crystalline) quartz or quartz glass powder.

In manufacturing by the rotating mold method, starting material powder is deposited on the inner surface of a rotated hollow mold; a means of heating such as arc discharge is used to vitrify the starting material powder by heating it; interior bubbles in the starting material powder layer are aspirated away from the mold side during this heating to achieve transparent vitrification; the reduced pressure aspiration period, heating and fusion period, and the like are controlled to adjust the content of bubbles in the transparent layer; and glass layers containing bubbles in the form of a semitransparent layer and opaque layer are obtained on the outside.

The starting material powder that is deposited, which is identical for the semitransparent layer and opaque layer, has a volumetric ratio of particles of 352 micrometers or less in size of 95 percent or greater, and a volumetric ratio of particles of 75 micrometers or less in size of 1.5 to 5 percent (referred to as "starting material powder A" hereinafter). The starting material quartz powders or quartz glass powders that are deposited to form the semitransparent layer and opaque layer desirably have the same particle size distribution. For the transparent layer, the starting material powder that is deposited has a volumetric ratio of particles 352 micrometers or less in size of 95 percent or greater, and a volumetric ratio of particles of 75 micrometers or less in size of 0 to less than 1.5 percent (referred to as "starting material powder B" hereinafter).

Starting material powder B is the starting material powder that is conventionally employed to manufacture crucibles having a transparent layer and an opaque layer. By contrast, no transparent layer can be formed by the conventional method when an attempt is made to fabricate a crucible having a transparent layer and an opaque layer using just starting material powder A.

When starting material B is employed in the transparent layer and starting material A is employed in the semitransparent and opaque layers, it is possible to form a transparent layer, semitransparent layer, and opaque layer by fusion by heating in about the same time and in about the same state of reduced pressure as by the conventional method.

Starting material powders A and B both equally contain a 95 percent or greater volumetric ratio of particles 352 micrometers or less in size, but differ in that the volumetric ratio of particles 75 micrometers or less in size is 1.5 to 5 percent and 0 to less than 1.5 percent, respectively. The particle size distribution of starting material powder A, which has a volumetric ratio of particles 75 micrometers or less in size of 1.5 to 5 percent, and that of starting material powder B, which has a volumetric ratio of particles 75 micrometers or less in size of 0 to less than 1.5 percent, are given in Table 1.

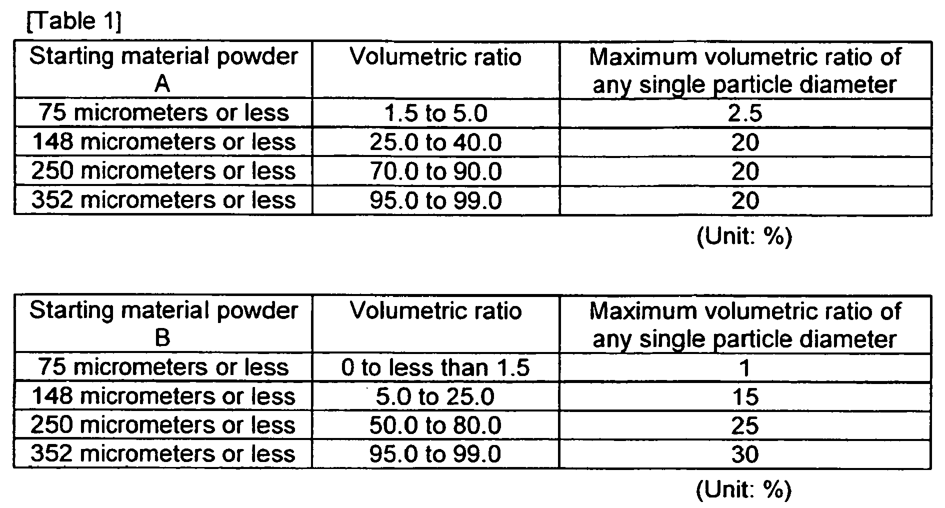

Employing a starting material powder in the form of starting material powder A having a different particle size distribution than is conventionally employed permits the manufacturing of a crucible having a transparent layer, semitransparent layer, and opaque layer.

The above quartz crucible can be manufactured by the rotating mold method. In manufacturing by the rotating mold method, the starting material quartz powder is deposited on the inner surface of a hollow mold that is being rotated, and the quartz powder is vitrified by heating with a means of heating such as arc discharge. Bubbles within the quartz powder layer are aspirated away from the mold side during this heating to achieve transparent vitrification, and the reduced pressure aspiration period, heating and fusion period, and the like are controlled to adjust the bubble content. The portion on the outer surface side is still opaque glass containing numerous bubbles.

### [Embodiments]

The present invention will be described in greater detail below through embodiments.

### Embodiments 1 to 12

The quartz crucible of the present invention was manufactured by the rotating mold method as follows. First, starting material powder A was deposited on the inner peripheral surface of a rotating mold. Next, starting material powder B was deposited thereover. The particle size distribution of starting material powders A and B was as indicated in Table 2 below. Next, arc discharging was conducted from the inner peripheral surface side of the mold to fuse and vitrify the surface of the quartz layers. Simultaneously, the pressure was reduced from the mold side and the air in the quartz portion was aspirated to the outer peripheral side through air holes provided in the mold and exhausted to the outside through air holes to eliminate bubbles in the surface portion of the quartz layer, thus forming a transparent glass layer. Subsequently, the pressure reduction was halted and the heating was continued to form nontransparent layers in which bubbles remained in the form of a semitransparent layer and an opaque layer. The thickness ratio (semitransparent layer: opaque layer) and the infrared radiation transmittance of the sidewall portion, curved portion, and bottom portion of the quartz crucible obtained were as indicated in Table 3. The bubble content of the transparent layer, semitransparent layer, and opaque layer are also given in Table 3. Silicon single crystals were pulled using this quartz crucible. The results (single crystallization rate) are also shown in Table 3.

**[Table 2]**

| | Volumetric ratio (%) | |
|---|---|---|
| | Starting material powder A | Starting material powder B |
| 75 micrometers or less | 2.39 | 0 |
| 148 micrometers or less | 31.51 | 9.59 |
| 250 micrometers or less | 80.88 | 59.4 |
| 352 micrometers or less | 97.46 | 97.04 |

The size of the quartz crucible was varied from 35.8 cm to 101.6 cm (14 inches to 40 inches) and the same testing was conducted. The results are given in Table 3. The bubble content given in Table 3 was measured by the following method. The bubble contents of the semitransparent layer and opaque layer were obtained by measuring the specific gravity. The bubble content of the transparent layer was measured by microscopic observation. The infrared radiation transmittance was measured by placing an infrared radiation powder meter with a heat-receiving surface of 1 cm² at a position 30 cm from an infrared radiation lamp with wavelengths of 0.5 to 3.5 micrometers and a peak wavelength of 1.0 micrometer, inserting a piece of crucible to be measured immediately in front of the heat-receiving surface, measuring the infrared radiation heat reception level, and calculating the transmittance using a heat reception level measured without the insertion of a piece of crucible as 100 percent. The average infrared radiation transmittance was the average of the values measured for each portion by this method. The single crystal yield was the ratio to a theoretical maximum single crystal yield of 100 percent.

**[Table 3]**

| Embodiment | | 1 | 2 | 3 | 4 | 5 | 6 | 7 | 8 | 9 | 10 | 11 | 12 |
|---|---|---|---|---|---|---|---|---|---|---|---|---|---|
| Size of crucible | | 35.8 cm (14") | 40.6cm (16") | 45.7cm (18") | 45.7cm (18") | 45.7cm (18") | 55.9cm (22") | 61cm (24") | 71.1cm (28") | 76.2cm (30") | 81.3cm (32") | 91.4cm (36") | 101.6cm (40") |
| Thickness ratio (%) Semitransparent layer: opaque layer | | 40:60 | 40:60 | 5:95 | 35:65 | 50:50 | 35:65 | 35:65 | 35:65 | 35:65 | 35:65 | 35:65 | 35:65 |
| Bubble content (%) of layer | Transparent | 0.05 | 0.05 | 0.05 | 0.05 | 0.05 | 0.05 | 0.05 | 0.05 | 0.05 | 0.05 | 0.05 | 0.05 |
| | Semitransparent | 0.4 | 0.4 | 0.5 | 0.5 | 0.5 | 0.5 | 0.5 | 0.5 | 0.5 | 0.5 | 0.6 | 0.7 |
| | Opaque | 1.8 | 1.8 | 2.0 | 2.0 | 2.0 | 2.0 | 2.0 | 2.0 | 2.0 | 2.0 | 2.5 | 3.0 |
| Infrared transmittance (%) | Wall portion | 68.5 | 67.4 | 58.3 | 65.9 | 70.9 | 64.7 | 60.7 | 57.4 | 56.9 | 53.3 | 53.1 | 50.3 |
| | Bend portion | 75.1 | 73.2 | 65.2 | 72.8 | 79.3 | 70.3 | 68.1 | 64.1 | 62.8 | 60.2 | 59.4 | 57.8 |
| | Bottom portion | 62.2 | 60.9 | 53.1 | 59.8 | 65.2 | 57.1 | 54.9 | 50.8 | 50.1 | 48 | 46.6 | 46.2 |
| Single crystal yield (%) | | 88 | 90 | 79 | 95 | 83 | 87 | 89 | 90 | 89 | 96 | 93 | 90 |

### Comparative Examples 1 to 3

Quartz crucibles that were 45.7cm (18 inches), 61 cm (24 inches), and 81.3 cm (32 inches) in size were similarly fabricated using only starting material powder B and silicon single crystals were pulled. The results (single crystallization rates) are given in Table 4.

**[Table 4]**

| Comparative Example | | 1 | 2 | 3 |
|---|---|---|---|---|
| Size of crucible | | 45.7cm (18") | 61cm (24") | 81.3cm (32") |
| Thickness ratio (%) Semitransparent layer: opaque layer | | 0:100 | 0:100 | 0:100 |
| Bubble content of opaque layer | | 2.0 | 2.0 | 2.0 |
| Infrared transmittance (%) | Wall portion | 56.7 | 62.3 | 49.2 |
| | Bend portion | 64.1 | 63.7 | 52.3 |
| | Bottom portion | 51.8 | 50.6 | 46.7 |
| Single crystal yield (%) | | 56 | 59 | 62 |

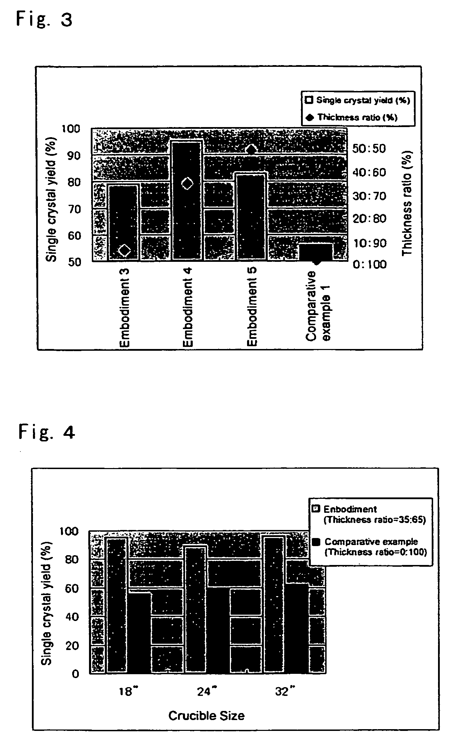

The relation between the proportions of the thickness ratio (semitransparent layer: opaque layer) and the single crystal yield of quartz crucibles that were 45.7 cm (18 inches) in size (Embodiments 3 to 5 and Comparative Example 1) are given in Fig. 3. The quartz crucible 45.7cm (18 inches) in size that had a thickness proportion of 30 percent afforded the highest single crystal yield.

The relation of the presence or absence of a semitransparent layer and the single crystal yield of quartz crucibles that were 45.7cm (18 inches), 61cm (24 inches), and 81.3cm (32 inches) in size (Embodiment 4 and Comparative Example 1; Embodiment 7 and Comparative Example 2, and Embodiment 10 and Comparative Example 3) are given in Fig. 4. It will be understood that providing a semitransparent layer greatly increased the single crystal yield for all sizes.

The present invention is useful in the field of manufacturing quartz crucibles for pulling silicon single crystals.

## Claims

1. A silica glass crucible employed in pulling silicon single crystals wherein the crucible comprises at least a transparent layer, semitransparent layer, and opaque layer disposed from the inner surface side to the outer surface side of the crucible, wherein a content of bubbles in the transparent layer is less than 0.3 percent; a content of bubbles in the semitransparent layer falls within a range of from 0.3 to 0.7 percent; and a content of bubbles in the opaque layer is greater than 1.0 percent, and wherein a ratio of the thicknesses of the semitransparent and opaque layers (semitransparent layer: opaque layer) falls within a range of from 15:85 to 50:50.

2. The silica glass crucible of claim 1, wherein a combined thickness of the semitransparent and opaque layers falls within a range of 5 to 50 mm.

3. The silica glass crucible of claim 2, wherein the combined thickness of the semitransparent and opaque layers falls within a range of 10 to 50 mm.

4. The silica glass crucible of claim 1, wherein the ratio of the thicknesses of the semitransparent and opaque layers (semitransparent layer: opaque layer) falls within a range of from 20:80 to 40:60.

5. The silica glass crucible of claim 1, wherein a thickness of a bottom portion in the transparent layer falls within a range of 0.5 to 10 mm.

6. The silica glass crucible of claim 5, wherein the thickness of a bottom portion in the transparent layer falls within a range of 2 to 5 mm.

## Patentansprüche

1. Quarzglastiegel, der beim Ziehen von Silicium-Einkristallen verwendet wird, wobei der Tiegel wenigstens eine transparente Schicht, halbtransparente Schicht und undurchsichtige Schicht umfasst, die von der inneren Oberflächenseite zur äußeren Oberflächenseite des Tiegels angeordnet sind, wobei ein Gehalt an Blasen in der transparenten Schicht kleiner ist als 0,3 Prozent; ein Gehalt an Blasen in der halbtransparenten Schicht in einen Bereich von 0,3 bis 0,7 Prozent fällt; und ein Gehalt an Blasen in der undurchsichtigen Schicht größer ist als 1,0 Prozent, und wobei ein Verhältnis der Dicken der halbtransparenten und undurchsichtigen Schicht (halbtransparente Schicht: undurchsichtige Schicht) in einen Bereich von 15:85 bis 50:50 fällt.

2. Quarzglastiegel nach Anspruch 1, wobei eine kombinierte Dicke der halbtransparenten und undurchsichtigen Schicht in einen Bereich von 5 bis 50 mm fällt.

3. Quarzglastiegel nach Anspruch 2, wobei die kombinierte Dicke der halbtransparenten und undurchsichtigen Schicht in einen Bereich von 10 bis 50 mm fällt.

4. Quarzglastiegel nach Anspruch 1, wobei das Verhältnis der Dicken der halbtransparenten und undurchsichtigen Schicht (halbtransparente Schicht: undurchsichtige Schicht) in einen Bereich von 20:80 bis 40:60 fällt.

5. Quarzglastiegel nach Anspruch 1, wobei eine Dicke eines Bodenabschnitts in der transparenten Schicht in einen Bereich von 0,5 bis 10 mm fällt.

6. Quarzglastiegel nach Anspruch 5, wobei die Dicke eines Bodenabschnitts in der transparenten Schicht in einen Bereich von 2 bis 5 mm fällt.

## Revendications

1. Un creuset en verre de silice employé pour le tirage de monocristaux de silicium, le creuset comprenant au moins une couche transparente, une couche semi-transparente et une couche opaque disposées du côté de la surface intérieure vers le côté de la surface extérieure du creuset, une teneur en bulles étant inférieure à 0,3 % dans la couche transparente ; une teneur en bulles étant dans une plage de 0,3 à 0,7 % dans la couche semi-transparente ; et une teneur en bulles étant supérieure à 1,0 % dans la couche opaque, et un rapport des épaisseurs des couches semi-transparente et opaque (couche semi-transparente : couche opaque) étant dans une plage de 15:85 à 50:50.

2. Le creuset en verre de silice de la revendication 1, une épaisseur combinée des couches semi-transparente et opaque étant dans une plage de 5 à 50 mm.

3. Le creuset en verre de silice de la revendication 2, l'épaisseur combinée des couches semi-transparente et opaque étant dans une plage de 10 à 50 mm.

4. Le creuset en verre de silice de la revendication 1, le rapport des épaisseurs des couches semi-transparente et opaque (couche semi-transparente : couche opaque) étant dans une plage de 20:80 à 40:60.

5. Le creuset en verre de silice de la revendication 1, une épaisseur de la portion inférieure de la couche transparente étant dans une plage de 0,5 à 10 mm.

6. Le creuset en verre de silice de la revendication 5, l'épaisseur de la portion inférieure de la couche transparente étant dans une plage de 2 à 5 mm.
